# EUROPEAN PATENT SPECIFICATION

(11) **EP 0 778 612 B1**
(45) Date of publication and mention of the grant of the patent: **18.07.2007**
(21) Application number: 96119378.6
(22) Date of filing: 03.12.1996
(51) Int. Cl.: C04B 41/00, C09D 183/04, C08J 3/28, C04B 41/45, C04B 35/14, H01L 21/316

(54) **Method of curing hydrogen silsesquioxane resin by electron beam to convert it to a silica containing ceramic coating**
Verfahren zur Härtung eines Wasserstoff-Silsesquioxanharzes mittels Elektronenstrahlen zur Umwandlung in eine Silika enthaltende Keramikbeschichtung
Méthode de traitement d'une résine hydrogène-silsesquioxane par faisceau d'électrons pour la convertir en un revêtement de céramique contenant de la silice

(30) Priority: 04.12.1995 US 566820
(43) Date of publication of application: 11.06.1997
(73) Proprietor: Dow Corning Corporation, Midland, Michigan 48686-0994 (US); NATIONAL SEMICONDUCTOR CORPORATION, Santa Clara California 95051 (US)
(72) Inventor: Camilletti, Robert Charles, Midland, Michigan 48640 (US); Saadat, Irfan, Santa Clara, California 95050 (US); Thomas, Michael, Milpitas, California 95035 (US)
(74) Representative: Spott, Gottfried

(56) References cited:
- EP-A- 0 510 872
- EP-A- 0 647 965
- US-A- 3 877 980
- US-A- 4 041 190
- US-A- 5 145 723
- BEREJKA A J: "Irradiation processing in the '90's: energy savings and environmental benefits" RADIATION PHYSICS AND CHEMISTRY,NL,ELSEVIER SCIENCE PUBLISHERS BV., AMSTERDAM, vol. 46, no. 4, page 429-437 XP004051106 ISSN: 0969-806X

## Description

The present invention introduces a method of forming silica-containing ceramic coatings on substrates such as electronic devices. These coatings are then used as hermetic and/or dielectric layers.

The use of hydrogen silsesquioxane derived ceramic coatings on substrates such as electronic devices is known in the art. For instance, this prior art is represented by U.S. Patents 4,756,977; 4,847,162; 5,059,448; 5,116,637, 5,336,532, 5,262,201 and 5,436,029. EP 0 647 965 A1 discloses a method of forming an Si-O containing coating on an electronic substrate from hydrogen silesquioxane resin (H-resin) and hydrogen gas. EP 0 510 872 A1 discloses a method of forming patterned coatings on substrates by negative resist techniques. The method comprises applying a preceramic coating comprising H-resin and an initiator onto the substrate, radiating a selected region of the coating to cure the resin and rinsing away uncuved coating. US 5,145,723 discloses a method of forming a silica coating on a substrate, which method comprises applying a coating comprising H-resin on a substrate. However, this prior art does not disclose heating a coating of H-resin on a substrate without substantially heating the substrate

We have now discovered that H-resin can be converted to silica-containing coatings without significantly heating the underlying substrate by using an electron beam.

This invention provides a method of forming a silica-containing ceramic coating on a substrate according to claim 1. The method comprises first applying a coating comprising H-resin on the substrate. The coated substrate is then exposed to an electron beam to convert the H-resin coating to a silica-containing ceramic coating. This method is especially valuable for forming hermetic and dielectric coatings on electronic devices.

The present invention is based on our finding that electron beams can expediently be used in the conversion of H-resin coatings to silica-containing coatings. This discovery has a surprising impact on the use of H-resin for coating temperature sensitive substrates, such as electronic devices, since the electron beam process can be tailored to inhibit appreciable temperature changes in the substrate.

Because our process forms such coatings at relatively low substrate temperatures, it is particularly effective for coating substrates, such as electronic devices or electronic circuits, which are temperature sensitive and which require high quality coatings. Such coatings serve, for example, as protective or dielectric coatings, interlevel dielectric layers, doped dielectric layers to produce transistor like devices, pigment loaded binder systems containing silicon to produce capacitor and capacitor like devices, multilayer devices, 3-D devices, silicon on insulator devices, coatings for superconductors and super lattice devices. The choice of substrates coated by the instant invention, however, is limited only by the need for thermal and chemical stability of the substrate under the conditions employed. It is also contemplated, therefore, that the process of the invention could be used on non-electronic substrates such as plastics including, for example, polyimides, epoxides, polytetrafluoroethylene and copolymers thereof, polycarbonates, acrylics and polyesters.

As used herein, the expression "silica-containing ceramic" is meant to include both amorphous silica (SiO₂) materials as well as amorphous silica-like materials that are not fully free of residual carbon, silanol (Si-OH) and/or hydrogen. The expressions "electronic device" or "electronic circuit" include, but are not limited to, silicon based devices, gallium arsenide based devices, focal plane arrays, opto-electronic devices, photovoltaic cells and optical devices.

In the present invention, a silica-containing ceramic coating is formed on a substrate by a process which comprises coating the substrate with a composition comprising H-resin and then exposing the coating to an electron beam.

The H-resin which may be used herein includes hydridosiloxane resins of the formula HSi(OH)ₓ(OR)_{y}O_{z/2}, in which each R is independently an organic group or a substituted organic group which, when bonded to silicon through the oxygen atom, forms a hydrolyzable substituent, x = 0-2, y = 0-2, z = 1-3, x + y + z = 3. Examples of R include alkyls such as methyl, ethyl, propyl and butyl; aryls such as phenyl; and alkenyls such as allyl or vinyl. As such, these resins may be fully condensed (HSiO_{3/2})ₙ, where n = 1 to 10; or they may be only partially hydrolyzed (i.e., containing some Si-OR) and/or partially condensed (i.e., containing some Si-OH). Although not represented by this structure, these resins may contain a small number (e.g., less than 10%) of silicon atoms which have either 0 or 2 hydrogen atoms attached thereto due to various factors involved in their formation or handling.

The above H-resins and methods for their production are known in the art. For example, US Patent 3,615,272 teaches the production of a nearly fully condensed H-resin (which may contain up to 100-300 ppm silanol) by a process comprising hydrolyzing trichlorosilane in a benzenesulfonic acid hydrate hydrolysis medium and by then washing the resultant resin with water or aqueous sulfuric acid. Similarly, U.S. Patent 5,010,159 describes an alternative method comprising hydrolyzing hydridosilanes in an arylsulfonic acid hydrate hydrolysis medium to form a resin which is then contacted with a neutralizing agent.

Other hydridosiloxane resins, such as those described by US Patent 4,999,397; those produced by hydrolyzing an alkoxy or acyloxy silane in an acidic, alcoholic hydrolysis medium; those described in JP-As 59-178749, 60-86017 and 63-107122 or any other equivalent hydridosiloxane, will also function herein.

It is noted that in a preferred embodiment of our invention, specific molecular weight fractions of the H-resin may also be used in this process. Such fractions and methods for their preparation are more fully described in US Patent 5,063,267. A preferred fraction comprises material wherein at least 75% of the polymeric species have a number average molecular weight above 1200 and a more preferred fraction comprises material wherein at least 75% of the polymeric species have a number average molecular weight between 1200 and 100,000.

The H-resin coating material may also contain other ceramic oxide precursors. Examples of such ceramic oxide precursors include compounds of various metals, such as aluminum, titanium, zirconium, tantalum, niobium and/or vanadium, as well as various non-metallic compounds such as those of boron or phosphorous, which may be dissolved in solution, hydrolyzed and subsequently pyrolyzed, at relatively low temperatures and relatively rapid reaction rates to form ceramic oxide coatings.

The above ceramic oxide precursor compounds generally have one or more hydrolyzable groups bonded to the above metal or non-metal, depending on the valence of the metal. The number of hydrolyzable groups included in these compounds is not critical as long as the compound is soluble in a solvent. Likewise, selection of the exact hydrolyzable substituent is not critical since the substituents are either hydrolyzed or pyrolyzed out of the system. Typical hydrolyzable groups include, but are not limited to, alkoxy, such as methoxy, propoxy, butoxy and hexoxy; acyloxy, such as acetoxy; or other organic groups bonded to said metal or non-metal through an oxygen, such as acetylacetonate. Specific compounds, therefore, include zirconium tetracetylacetonate, titanium dibutoxy diacetylacetonate, aluminum triacetyl-acetonate and tetraisobutoxy titanium.

When H-resin is combined with one of the above ceramic oxide precursors, it is used in an amount such that the final ceramic coating contains 70 to 99.9 percent by weight of SiO₂.

The H-resin coating material may also contain a platinum, rhodium or copper catalyst to increase the rate and extent of conversion to silica. Generally, any platinum, rhodium or copper compound or complex which can be solubilized will be functional. For instance, a composition such as platinum acetylacetonate, rhodium catalyst RhCl₃[S(CH₂CH₂CH₂CH₃)₂]₃, obtained from Dow Corning^{™} Corporation, Midland, Michigan, or cupric naphthenate are all feasible choices. These catalysts are generally added in an amount of between 5 to 1000 ppm of platinum, rhodium or copper, based on the weight of H-resin.

According to the invention, H-resin and, optionally, any ceramic oxide precursors and/or catalysts, are applied to the surface of a substrate. This is accomplished in any manner, but a preferred method involves dissolving the H-resin in a solvent to form a solution or dispersion which is applied to the surface of the substrate. Various facilitating measures such as stirring and/or heating may also be used to dissolve or disperse the H-resin and create a more uniform application solution. Solvents which are used include any agent or mixture of agents, which will dissolve or disperse the H-resin to form a homogenous solution without affecting the resultant coating. These solvents include, for example, aromatic hydrocarbons such as benzene or toluene; alkanes such as n-heptane or dodecane; ketones; esters; ethers or cyclic dimethylpolysiloxanes, in an amount sufficient to dissolve the above materials to low solids content. Generally, enough of the above solvent is used to form a 0.1-50 weight percent solution.

If a solution method is used, the solution comprising the H-resin, solvent and, optionally, a modifying ceramic oxide precursor and/or a catalyst is then coated onto the substrate. The method of coating is spin coating, dip coating, spray coating or flow coating. Other equivalent means, such as vapor deposition, are also valuable.

The solvent is then allowed to evaporate from the coated substrate resulting in the deposition of the H-resin coating. Any suitable means of evaporation may be used such as simple air drying by exposure to an ambient environment, by the application of a vacuum or mild heat (e.g., less than 50°C.) or during the early stages of the heat treatment. It is noted that when spin coating is used, the additional drying period is minimized as the spinning process also drives off the solvent.

Once the H-resin coating is applied, it is then exposed to an electron beam (EB). Units for producing electron beams are known in the art and commercially available. Generally, such units comprise a heated cathode (such as a tungsten filament) which cause electrons to be produced at a very high rate. The resultant electrons are then accelerated and concentrated in vacuum (20 m Torr or 2.7 Pa) by a large voltage applied to the anode to form a high energy beam. The coating is heated by absorbing the kinetic energy of these bombarding electrons. Alternatively, cold cathode sources are also useful.

Typically, the accelerating voltage in these units is in the range of 0.1 to 100 keV, the vacuum is in the range of 10 to 10⁻³ Pa, the electron currents range from 0.1 milliamperes to 1 ampere and the power in the beam varies from 0.1 watt to 1 kilowatt. The dose achieved by these means is in the range of 100 microcoulomb to 100 coulomb per square centimer, preferably in the range of 1 to 10 coulombs/cm².

The H-resin coating is then exposed to the electron beam for a time effective to provide the dose required to convert the H-resin to silica. Generally, depending on the voltage, this occurs within a range from 10 seconds to 1 hour.

We have also unexpectedly discovered that the dose of the electron beam has an impact on the properties of the coating. For instance, when the electron beam dose is increased at a constant accelerating voltage, the stress in the coating is surprisingly changed from tensile to compressive. As such, the processing can be tailored to form coatings with any desired property.

Despite the high energy absorbed by our coating in this process, substrate temperatures are not appreciably affected. For instance, in a standard conversion process, substrate temperatures rarely reach 100°C. and are often less than 50°C.

If desired, the coating is selectively exposed to the electron beam by the use of a mask to cure only portions of the coating. After exposure, the remainder of the coating (i.e., the uncured coating) is removed (by rinsing with a solvent) to yield a patterned coating.

Additionally, it is possible to anneal the coating cured with an electron beam in any desired environment. For instance, the coating can be heated at 50-500°C in an inert gas or an oxidizing gas for up to 72 hours. Such annealing process can also change the characteristics and properties of the coating.

Finally, the coating may be further planarized by, for example, heating before or during electron beam exposure to cause the coating to melt and flow.

By the above methods, a thin (less than 2 micrometers) silica-containing ceramic planarizing coating is produced on a temperature sensitive substrate. The coating smooths the irregular surfaces of various substrates and has excellent adhesive properties. In addition, the coating may be covered by other coatings such as additional SiO₂ layers, silicon containing coatings, silicon carbon containing coatings, silicon nitrogen containing coatings, silicon oxygen nitrogen containing coatings and/or silicon nitrogen carbon containing coatings. Such multiple layer coatings are known in the art and many are described in US Patent 4,756,977.

Coatings produced by the instant invention have low defect density and are useful on electronic devices as protective coatings, as corrosion resistant and abrasion resistant coatings, as temperature and moisture resistant coatings, as dielectric layers and as a diffusion barrier against ionic impurities such as sodium and chloride.

### Embodiment 1

Hydrogen silsesquioxane resin (H-resin) made by the method of US Patent 3,615,273 was diluted to 18 wt% in methyl isobutylketone. The H-resin solution was then applied to the surface of a 150 mm silicon wafer by a spin-on process. The coating on the wafer was then exposed to electron beams as set forth in Table 1. The results are also in the Table. Note that substrate temperatures were typically in the 35-45°C. range upon exposure.

**TABLE I - KEY**

| Column No. | |
|---|---|
| 1 - | Sample Description |
| 2 - | Acceleration Voltage (Electron Volts) |
| 3 - | Dose (µC/cm²) |
| 4 - | Unconverted Coating Thickness (A°) |
| 5 - | Standard Deviation of Unconverted Coating Thickness (A°) |
| 6 - | Converted Coating Thickness (A°) |
| 7 - | Standard Deviation of Converted Coating Thickness (A°) |
| 8 - | Measured Refractive Index |
| 9 - | % Shrinkage |
| 10 - | Film Density (g/cm³) |
| 11 - | Remaining % SiOH (wt/wt%) |
| 12 - | % SiH by FTIR |
| 13 - | % H₂O (wt/wt%) |
| 14 - | Initial Stress (10⁸ dynes/cm²) |
| 15 - | Dielectric Constant (100 Hz) |
| 16 - | Dissipation Factor (100 Hz) |
| 17 - | Dielectric Constant (1 MHz) |
| 18 - | Dissipation Factor (1 MHz) |
| 19 - | Volume Resistivity (1-19 volts) |

**TABLE I - ELECTRON BEAM CURING OF HYDROGEN SILSESQUIOXANE RESIN**

| 1 | 2 | 3 | 4 | 5 | 6 | 7 | 8 | 9 | 10 | 11 | 12 | 13 | 14 | 15 | 16 | 17 | 18 | 19 |
|---|---|---|---|---|---|---|---|---|---|---|---|---|---|---|---|---|---|---|
| 1 Electron Cure | 800 | 100 | 5306 | 8 | 5520 | 17 | 1.37 | -4.0 | 1.542 | 98.79 | 0.76 | 0.00 | 3.53 | | | | | |
| 2 Electron Cure | 800 | 100 | 5278 | 36 | | | | 100.0 | ERR | | | | | | | | | |
| 3 Electron Cure | 800 | 100 | 5287 | 34 | | | | 100.0 | ERR | | | | | | | | | |
| 4 Electron Cure | 800 | 200 | 5293 | 37 | 5512 | 45 | 1.369 | -4.1 | 1.461 | 99.08 | 0.73 | 0.00 | 2.68 | | | | | |
| 5 Electron Cure | 800 | 200 | 5205 | 37 | | | | 100.0 | ERR | | | | | | | | | |
| 6 Electron Cure | 800 | 200 | 5299 | 32 | | | | 100.0 | ERR | | | | | | | | | |
| 7 Electron Cure | 800 | 300 | 5290 | 10 | 5514 | 29 | 1.368 | -4.1 | 1.439 | 100.00 | 0.87 | 0.00 | 3.30 | | | | | |
| 8 Electron Cure | 800 | 300 | 5069 | 16 | | | | 100.0 | ERR | | | | | | | | | |
| 9 Electron Cure | 800 | 300 | 5311 | 28 | 5544 | 25 | 1.366 | -4.4 | 1.317 | | | | 3.32 | | | | | |
| 10 Electron Cure | 4600 | 100 | 6243 | 63 | 5106 | 42 | 1.401 | 2.6 | 1.509 | 76.50 | 1.15 | 0.00 | 4.51 | | | | | |
| 11 Electron Cure | 4600 | 100 | 5310 | 35 | 5162 | 32 | 1.401 | 2.8 | 1.526 | 76.20 | 1.12 | 0.00 | 4.13 | | | | | |
| 12 Electron Cure | 4600 | 100 | 5264 | 43 | 5127 | 55 | 1.4 | 2.6 | 1.503 | | | | 3.37 | | | | | |
| 13 Electron Cure | 4600 | 200 | 5297 | 41 | 5009 | 28 | 1.418 | 5.4 | 1.561 | 64.67 | 2.18 | 0.28 | 3.54 | 3.27 | 0.0026 | 3.25 | 0.0328 | 7.67E+16 |
| 14 Electron Cure | 4600 | 200 | 5171 | 36 | 4911 | 18 | 1.426 | 5.0 | 1.604 | 67.85 | 2.03 | 0.24 | 1.65 | | | | | |
| 15 Electron Cure | 1600 | 200 | 5155 | 33 | 4918 | 19 | 1.431 | 4.6 | 1.590 | | | | 1.62 | | | | | |
| 16 Electron Cure | 4600 | 300 | 5141 | 37 | 4871 | 31 | 1.43 | 5.3 | 1.653 | 63.26 | 2.62 0.40 | | 0.59 | 3.56 | 0.0002 | 3.48 | 0.0152 | 6.19E+16 |
| 17 Electron Cure | 4600 | 300 | 5141 | 44 | 4079 | 32 | 1.420 | 5.1 | 1.638 | 59.91 | 2.65 | 0.41 | 0.90 | | | | | |
| 18 Electron Cure | 4600 | 300 | 5159 | 22 | 4002 | 17 | 1.432 | 5.4 | 1.484 | | | | 0.63 | | | | | |
| 19 Electron Cure | 6800 | 100 | 5120 | 30 | 4085 | 22 | 1.421 | 4.6 | 1.648 | 47.90 | 2.90 | 0.30 | 2.45 | 3.79 | 0.0004 | 3.60 | 0.041 | 2.70E+10 |
| 20 Electron Cure | 6800 | 100 | 5143 | 36 | 5017 | 21 | 1.407 | 2.4 | 1.570 | 07.31 | 1.38 | 0.00 | 2.54 | | | | | |
| 21 Election Cure | 6800 | 100 | 5117 | 44 | 5005 | 47 | 1.409 | 2.2 | 1.494 | | | | 1.89 | | | | | |
| 22 Election Cure | 6600 | 200 | 5131 | 23 | 4904 | 42 | 1.42 | 4.4 | 1.700 | 47.51 | 2.90 | 0.28 | 1.47 | 3.51 | 0.0001 | 3.48 | 0.0484 | 2.81E+17 |
| 23 Electron Cure | 6800 | 200 | 5160 | 19 | 4933 | 24 | 1.419 | 4.4 | 1.644 | 49.71 | 2.75 | 0.23 | 1.69 | | | | | |
| 24 Election Cure | 6600 | 200 | 5149 | 47 | 4931 | 40 | 1.421 | 4.2 | 1.714 | | | | 1.37 | | | | | |
| 25 Election Cure | 6600 | 300 | 5106 | 34 | 4805 | 12 | 1.432 | 5.9 | 1.771 | 38.39 | 3.65 | 0.04 | | 4.11 | 0.0001 | 4.04 | 0.0373 | 7.29E+16 |
| 28 Electron Cure | 6600 | 300 | 5351 | 92 | 5052 | 99 | 1.429 | 5.6 | 1.753 | 36.97 | 3.35 | 0.47 | 0.23 | | | | | |
| 27 Electron Cure | 6000 | 300 | 5124 | 25 | 4818 | 33 | 1.433 | 6.0 | 2.053 | | | | -0.17 | 4.50 | 0.0007 | 4.35 | 0.0497 | 3.05E+17 |
| | | | | | | | | | | | | | | | | | | |
| 31 Election Cure | 6800 | 300 | 5204 | 49 | 4738 | 46 | 1.448 | 9.0 | 1.711 | 37.00 | 4.76 | 1.01 | 16.28 | | | | | |
| 32 Election Cure | 6600 | 300 | 5138 | 81 | 4652 | 93 | 1.451 | 9.5 | 1.669 | 39.60 | 4.58 | 0.88 | 0.36 | | | | | |
| 33 Election Cure | 6000 | 300 | 5200 | 40 | 4704 | 49 | 1.451 | 9.7 | 1.730 | | | | 0.34 | | | | | |
| 34 Electron Cure | 6000 | 600 | 5170 | 52 | 4541 | 51 | 1.473 | 12.3 | 1.710 | 32.50 | 5.96 | 1.54 | -4.21 | 4.59 | 0.0015 | 4.42 | 0.0001 | 4.36E+15 |
| 35 Electron Cure | 6800 | 600 | 5210 | 38 | 4704 | 133 | 1.465 | 9.7 | 1.773 | 32.20 | 5.15 | 1.11 | -4.55 | | | | | |
| 36 Electron Cure | 6800 | 600 | 5247 | 50 | 4649 | 69 | 1.465 | 11.4 | 1.744 | | | | -3.72 | | | | | |
| 37 Electron Cure | 6800 | 900 | 5211 | 36 | 4479 | 52 | 1.489 | 14.0 | 1.874 | 30.90 | 4.95 | 1.38 | -6.47 | 5.10 | 0.0021 | 4.73 | 0.0002 | 1.01E+18 |
| 38 Electron Cure | 6800 | 900 | 5213 | 34 | 4503 | 24 | 1.485 | 13.6 | 2.082 | 30.80 | 4.45 | 1.10 | -6.29 | | | | | |
| 39 Electron Cure | 6800 | 900 | 5302 | 52 | 4591 | 49 | 1.478 | 13.4 | 1.979 | | | | -5.54 | 4.95 | 0.0007 | 4.68 | 0.0009 | 6.28E+15 |
| | | | | | | | | | | | | | | | | | | |
| 26 Unconverted | - | 0 | 5372 | 105 | 5537 | 126 | 1.36 | -3.1 | 1.527 | 96.04 | 0.75 | 0.00 | 2.40 | | | | | |

### Example 2 (Comparative)

H-resin made by the method of US Patent No. 3,615,273 was diluted to 18 wt% in methyl isobutylketone. This H-resin solution was next applied to the surface of a silicon wafer by a spin-on process. The coated wafer was then placed in a 1 L 2 inch quartz tube furnace at 400°C in nitrogen for 1 hour. The resultant coating had the following characteristics: (note that substrate temperatures are at 400°C.)

| | Heat Cured | Electron Beam Cured |
|---|---|---|
| Film Density | 1.4 to 1.45 g/cm³ | 1.32 to 2.08 |
| Refractive Index | 1.38 | 1.37 to 1.49 |
| Stress (dynes/cm²) | 1 x 10⁹ (T) | -3.72 to 16.28 x 10⁸ |
| Remaining SiH | >90% | 30.8 to 100% |
| SiOH | <0.5% | 0.73 to 5.96% |
| H₂O | 0.0% | 0.0 to 1.54% |

## Claims

1. A method of forming a silica-containing ceramic coating on a substrate comprising:
applying a coating comprising hydrogen silsesquioxane resin on a substrate; and
heating the coating by exposing the coated substrate to an electron beam for a time in the range of 10 seconds to 1 hour and at a dose in the range of 100 µC/cm² to 100 C/cm² to convert the hydrogen silsesquioxane resin coating to a silica-containing ceramic coating having a desired tensile or compressive stress.

2. The method of claim 1 wherein the substrate is an electronic device.

3. The method of claim 1 wherein the hydrogen silsesquioxane resin coating also contains ceramic oxide precursors comprising a compound containing an element selected from the group consisting of titanium, zirconium, aluminum, tantalum, vanadium, niobium, boron and phosphorous wherein the compound contains at least one hydrolyzable substituent selected from the group consisting of alkoxy or acyloxy and the compound is present in an amount such that the silica-containing ceramic coating contains 0.1 to 30 percent by weight of ceramic oxide precursor.

4. The method of claim 1 wherein the hydrogen silsesquioxane resin coating also contains a platinum or rhodium catalyst in an amount of between 5 and 1000 ppm of platinum or rhodium based on the weight of hydrogen silsesquioxane resin.

5. The method of claim 1 wherein the coated substrate is selectively exposed to the electron beam to form a patterned coating.

6. The method of claim 1 wherein the coated substrate exposed to the electron beam is annealed for up to 72 hours at 50-500°C. in an atmosphere selected from inert gas, oxidizing gas and reducing gas.

7. The method of claim 1 wherein the coating is heated before or during the electron beam exposure to cause it to melt and flow.

## Patentansprüche

1. Verfahren zur Bildung einer Siliciumoxid enthaltenden keramischen Beschichtung auf einem Substrat, umfassend:
Aufbringen einer Hydrogensilsesquioxanharz umfassenden Beschichtung auf ein Substrat und
Erwärmen der Beschichtung durch Aussetzen des beschichteten Substrats einem Elektronenstrahl über einen Zeitraum in dem Bereich von 10 Sekunden bis 1 Stunde und in einer Dosis in dem Bereich von 100 µC/cm² bis 100 C/cm², um die Hydrogensilsesquioxanharzbeschichtung in eine Siliciumoxid enthaltende keramische Beschichtung zu überführen, die eine gewünschte Zug- oder Druckspannung aufweist.

2. Verfahren nach Anspruch 1, wobei das Substrat für eine elektronische Vorrichtung steht.

3. Verfahren nach Anspruch 1, wobei die Hydrogensilsesquioxanharzbeschichtung auch Vorläufer für keramisches Oxid enthält, die eine Verbindung umfassen, die ein Element enthält, das ausgewählt ist aus der Gruppe, bestehend aus Titan, Zirconium, Aluminium, Tantal, Vanadium, Niob, Bor und Phosphor, wobei die Verbindung mindestens einen hydrolysierbaren Substituenten enthält, der ausgewählt ist aus der Gruppe, bestehend aus Alkoxy oder Acyloxy, und die Verbindung in einer Menge vorliegt, so dass die Siliciumoxid enthaltende keramische Beschichtung 0,1 bis 30 Gew.-% von dem Vorläufer für keramisches Oxid enthält.

4. Verfahren nach Anspruch 1, wobei die Hydrogensilsesquioxanharzbeschichtung auch einen Platin- oder Rhodiumkatalysator in einer Menge von zwischen 5 und 1000 ppm an Platin oder Rhodium, bezogen auf das Gewicht des Hydrogensilsesquioxanharzes, enthält.

5. Verfahren nach Anspruch 1, wobei das beschichtete Substrat selektiv dem Elektronenstrahl ausgesetzt wird, um eine gemusterte Beschichtung zu bilden.

6. Verfahren nach Anspruch 1, wobei das beschichtete Substrat, das dem Elektronenstrahl ausgesetzt wird, bis zu 72 Stunden bei 50 bis 500 °C in einer Atmosphäre, die aus Inertgas, oxidierendem Gas und reduzierendem Gas ausgewählt wird, geglüht wird.

7. Verfahren nach Anspruch 1, wobei die Beschichtung erwärmt wird vor oder während sie dem Elektronenstrahl ausgesetzt wird, um zu bewirken, dass sie schmilzt und fließt.

## Revendications

1. Procédé de formation d'un revêtement de céramique contenant de la silice sur un substrat comprenant :
d'appliquer un revêtement comprenant une résine d'hydrogénosilsesquioxane sur un substrat ; et
de chauffer le revêtement en exposant le substrat recouvert à un faisceau d'électrons pendant une durée comprise dans la plage de 10 secondes à 1 heure et à une dose comprise dans la plage de 100 µC/cm² à 100 C/cm² pour convertir le revêtement de résine d'hydrogénosilsesquioxane en un revêtement de céramique contenant de la silice ayant une tension due aux efforts de traction ou de compression souhaitée.

2. Procédé de la revendication 1 dans lequel le substrat est un dispositif électronique.

3. Procédé de la revendication 1 dans lequel le revêtement de résine d'hydrogénosilsesquioxane contient également des précurseurs d'oxyde céramique comprenant un composé contenant un élément choisi dans le groupe constitué du titane, du zirconium, de l'aluminium, du tantale, du vanadium, du niobium, du bore et du phosphore, ledit composé contenant au moins un substituant hydrolysable choisi dans le groupe constitué de groupes alcoxy ou acyloxy et ledit composé étant présent en quantité telle que le revêtement de céramique contenant de la silice contient 0,1 à 30 pour cent en poids de précurseur d'oxyde céramique.

4. Procédé de la revendication 1 dans lequel le revêtement de résine d'hydrogénosilsesquioxane contient également un catalyseur à base de platine ou de rhodium en quantité comprise entre 5 et 1000 ppm de platine ou de rhodium sur la base du poids de la résine d'hydrogénosilsesquioxane.

5. Procédé de la revendication 1 dans lequel le substrat recouvert est sélectivement exposé au faisceau d'électrons pour former un revêtement imprimé.

6. Procédé de la revendication 1 dans lequel le substrat recouvert exposé au faisceau d'électrons est recuit pendant une durée allant jusqu'à 72 heures à 50-500°C dans une atmosphère choisie entre un gaz inerte, un gaz oxydant et un gaz réducteur.

7. Procédé de la revendication 1 dans lequel le revêtement est chauffé avant ou pendant l'exposition au faisceau d'électrons pour le faire fondre et couler.
